# FASCICULE DE BREVET EUROPEEN

(11) **EP 3 465 724 B1**
(45) Date de publication et mention de la délivrance du brevet: **13.05.2020**
(21) Numéro de dépôt: 17731220.4
(22) Date de dépôt: 19.05.2017
(51) Int. Cl.: H01H 59/00

(54) **MEMBRANE MEMS À LIGNE DE TRANSMISSION INTÉGRÉE**
MEMS-MEMBRAN MIT INTEGRIERTER ÜBERTRAGUNGSLEITUNG
MEMS MEMBRANE WITH INTEGRATED TRANSMISSION LINE

(30) Priorité: 24.05.2016 FR 1654615
(43) Date de publication de la demande: 10.04.2019
(73) Titulaire: Airmems, 87069 Limoges (FR)
(72) Inventeur: STEFANINI, Romain, 87000 Limoges (FR); ZHANG, Ling Yan, 87310 Cognac La Foret (FR); ZAHR, Abedel Halim, 87100 Limoges (FR)
(74) Mandataire: Cabinet Chaillot
(86) Numéro de dépôt international: PCT/FR2017/051239
(87) Numéro de publication internationale: WO 2017/203141

(56) Documents cités:
- EP-A2- 0 709 911
- EP-A2- 1 798 745
- WO-A1-2004/030005
- US-A1- 2014 184 028

## Description

La présente invention concerne le domaine des systèmes microélectromécaniques (MEMS) pour les radiofréquences, désignés par l'acronyme MEMS RF.

Les systèmes microélectromécaniques radiofréquences (MEMS RF) permettent de réaliser des opérations de commutation pour des applications adressant une large gamme de fréquences (DC-200 GHz).

De manière générale, ce type de composant est conçu en technologie coplanaire ou microruban d'impédance caractéristique 50 ou 75 Ohms afin d'assurer un guidage optimal de l'onde sur l'ensemble de la puce. Cependant, limiter les effets parasites et maintenir l'adaptation RF de la membrane MEMS à des fréquences élevées (>20 GHz) impose des contraintes technologiques.

Le document EP1798745 décrit un commutateur selon le préambule de la revendication 1.

En effet, l'état de l'art des commutateurs MEMS RF présente la membrane mécanique comme étant :
- soit totalement réalisée en métal ou recouverte de métal, donc entièrement conductrice. Dans ce cas, des capacités parasites créées entre les entrées et sorties du commutateur ont souvent pour conséquence une limitation en fréquence. De plus, en configuration série coplanaire, les masses RF disposées sur le substrat sont généralement agrandies ou rétrécies au niveau de la membrane du MEMS afin d'améliorer l'adaptation mais ne suffisent pas pour assurer de bonnes performances à hautes fréquences ;
- soit partiellement métallique. Dans ce cas, elle est souvent composée d'une ligne conductrice permettant de véhiculer des signaux RF et d'une ou plusieurs électrodes permettant l'activation du MEMS. Ainsi, la masse RF est dans la majorité des cas amenée sur le substrat, en dessous de la membrane, face aux électrodes d'activation. Cette configuration permet d'atteindre des fréquences élevées mais limite la surface d'activation et donc nécessite la conception d'une membrane plus grande pour garantir une force de contact élevée (supérieure à 100 µN) et donc une bonne fiabilité. De plus, ce type de composant est toujours présenté en série et peut difficilement être implémenté en configuration parallèle

La Demanderesse se propose de résoudre ces problèmes en disposant la masse RF au niveau de la membrane du MEMS. Cette configuration présente l'avantage de pouvoir maintenir les performances RF à des fréquences élevées (> 50 GHz), conserver une force d'activation du MEMS relative à plus de 90% de la surface mécanique de la membrane dans la plupart des cas, améliorer la tenue en puissance en contrôlant la circulation des courants sur la membrane et permettre une intégration simple du composant en configuration parallèle sans affecter les propriétés mécaniques de la membrane.

La présente invention a donc pour objet un commutateur microélectromécanique (MEMS) formé sur un substrat, le commutateur microélectromécanique comprenant :
- une première ligne de signal RF et une deuxième ligne de signal RF formées sur le substrat ;
- une membrane déformable en matériau hautement résistif, la membrane étant maintenue, dans un état non déformé, espacée du substrat par des moyens d'ancrage solidaires du substrat,
- un moyen d'activation configuré pour déformer la membrane à partir de son état non déformé,
- une piste de substrat formée sur le substrat, en regard de la membrane,
- une piste de membrane intégrée à la membrane et portant une zone de contact conductrice en regard de la piste de substrat configurée pour réaliser un contact conducteur entre la piste de substrat et la piste de membrane dans un état déformé de la membrane, la première ligne de signal RF et la deuxième ligne de signal RF étant reliées par l'intermédiaire d'au moins l'une parmi la piste de membrane et la piste de substrat, le commutateur étant à l'état passant lorsqu'un signal est apte à circuler de la première ligne de signal RF à la deuxième ligne de signal RF, et à l'état bloqué lorsqu'un signal ne peut pas circuler de la première ligne de signal RF à la deuxième ligne de signal RF,
caractérisé par le fait qu'une masse RF de membrane est intégrée à la membrane, la masse RF de membrane étant reliée électriquement à une masse RF de substrat par l'intermédiaire des ancrages, la masse RF de membrane encadrant et étant formée parallèlement à au moins l'une parmi la piste de membrane et la piste de substrat, de telle sorte que la masse RF épouse le trajet de signal RF, pour guider la propagation du signal RF de la première ligne de signal RF à la deuxième ligne de signal RF lorsque le commutateur est à l'état passant.

On assure ainsi un guidage du signal RF dans le composant, quelle que soit sa configuration : série ou parallèle.

Il est à noter que la configuration série est la configuration dans laquelle le commutateur permet le passage des courants RF de l'entrée vers la sortie lorsqu'il est activé. A l'inverse, un commutateur en configuration parallèle redirigera les courants vers la masse RF une fois activé.

Il est à noter également que la masse RF est différente de la masse DC du commutateur. La masse RF est définie comme étant l'une parmi une ligne ou un ensemble de lignes conductrices portant un potentiel électrique de référence vis-à-vis du potentiel électrique de signal, disposée(s) le long de la ligne de signal radiofréquence et permettant le guidage de l'onde radiofréquence de l'entrée vers la sortie du dispositif. La ligne de masse RF assure une continuité électrique de la ligne d'entrée RF vers la ligne de sortie RF. La disposition de la masse RF vis-à-vis de la ligne de signal détermine l'impédance caractéristique du guide d'onde.

La masse DC quant à elle est définie comme l'une parmi une ligne ou un ensemble de lignes conductrices véhiculant un potentiel électrique de référence vis-à-vis du potentiel électrique nécessaire à l'activation du composant. La ligne de masse RF et la ligne de masse DC peuvent représenter la même ligne conductrice. Néanmoins, la ligne de masse DC à elle seule, ne peut guider localement le signal RF de l'entrée vers la sortie du dispositif.

Le verbe « encadrer » est utilisé dans la présente demande dans un sens large, c'est-à-dire que la masse RF de membrane peut être située, pour la piste de membrane, au-dessus, de part et d'autre, en dessous, ou une combinaison des trois, par rapport à la piste de membrane. Des configurations de masse RF coplanaire (acronyme anglais CPW ou CPWG pour guide d'onde coplanaire), microruban (en anglais microstrip), triplaque (en anglais stripline) ou guide d'onde intégré au substrat (acronyme anglais SIW pour surface integrated waveguide) peuvent être indiquées comme des configurations dans lesquelles la masse RF de membrane encadre la piste de membrane. Il est à noter que dans le cas où les lignes de masse RF encadrent la ligne de substrat, la masse RF de membrane est configurée de telle sorte que sa projection dans le plan de la piste de substrat est située de part et d'autre de la piste de substrat.

La première ligne de signal RF peut être l'une parmi la ligne d'entrée de signal RF et la ligne de sortie de signal RF du commutateur, la deuxième ligne de signal RF étant l'autre parmi la ligne d'entrée de signal RF et la ligne de sortie de signal RF du commutateur.

La membrane déformable peut être maintenue espacée du substrat par un ou plusieurs ancrages formés sur au moins l'un parmi le substrat et toute autre structure micromécanique formée sur le substrat. La membrane déformable, dans son état non déformé, est généralement sensiblement parallèle au substrat.

Le moyen d'activation peut être au moins l'un parmi un moyen d'activation électrostatique, un moyen d'activation piézoélectrique, un moyen d'activation thermique et un moyen d'activation par induction.

Dans la présente invention, le commutateur, s'il est à actionnement électrostatique, peut présenter une séparation entre la face inférieure de la membrane et le moyen d'activation qui est sans diélectrique ou avec espace d'air (en anglais « dielectric less » ou « air gap », c'est-à-dire qu'il n'y a pas de diélectrique entre l'électrode d'activation et la membrane).

Dans la présente demande, on entend par membrane en matériau hautement résistif une membrane diélectrique ou semi-conductrice.

La membrane est ainsi de préférence un matériau diélectrique mais peut être un matériau hautement résistif ou semi-conducteur.

On entend dans la présente demande par le terme diélectrique une ou plusieurs couches de matériaux différents, séparant plusieurs éléments conducteurs et isolant électriquement ces éléments conducteurs.

Le diélectrique peut notamment être un matériau de résistance électrique supérieure à 5x10⁴ Ohms.cm, par exemple SiO₂, SiN, Si₃N₄, AlN, Al₂O₃ ou GaN.

Lorsque la membrane est constituée par un matériau semiconducteur ou hautement résistif, celui-ci peut être un matériau de résistance électrique comprise entre 5x10² et 5x10³ Ohms.cm, par exemple SiGe, Silicium ou AsGa.

Les masses RF, les lignes de signal RF ainsi que les pistes de membrane et de substrat peuvent être réalisées en tout métal, étant de préférence réalisées en or, en cuivre, en aluminium, ou en tungstène, ou un alliage de ces métaux.

L'électrode d'activation peut également être réalisée en tout métal, en un matériau résistif tel que SiCr, ou en carbone dopé par nickel, silicium dopé, TiW.

Dans la présente demande, on considérera que le signal ne circule pas si le signal de sortie est atténué d'au moins 15dB par rapport au signal d'entrée. Ainsi, si le signal RF est isolé de 15dB ou plus entre la première ligne de signal RF et la deuxième ligne de signal RF, on considérera que le signal RF ne circule pas entre ces deux lignes. A contrario, si le signal RF est isolé de moins de 15dB, on considérera que le signal RF circule entre ces deux lignes.

Le substrat peut être diélectrique ou semi-conducteur. Il peut s'agir notamment et de manière non limitative d'une ou plusieurs couches à base de quartz, SiO₂, silicium, SiGe, SiN, AlN, GaN.

Selon un premier mode de réalisation correspondant à un MEMS en configuration série, la piste de membrane est reliée au niveau d'une extrémité à la première ligne de signal RF et la piste de substrat est reliée à la deuxième ligne de signal RF, l'état passant du commutateur étant réalisé dans l'état déformé de la membrane, et l'état bloqué du commutateur étant réalisé dans un état non déformé de la membrane.

Selon un deuxième mode de réalisation correspondant à un MEMS selon une première configuration parallèle, la première ligne de signal RF et la deuxième ligne de signal RF sont reliées par la piste de membrane, la piste de substrat étant reliée à la masse RF, l'état bloqué du commutateur étant réalisé dans l'état déformé de la membrane, et l'état passant du commutateur étant réalisé dans l'état non déformé de la membrane.

Selon un troisième mode de réalisation correspondant à un MEMS dans une seconde configuration parallèle, la première ligne de signal RF et la deuxième ligne de signal RF sont reliées par la piste de substrat, la piste de membrane étant reliée à la masse RF, l'état bloqué du commutateur étant réalisé dans l'état déformé de la membrane, et l'état passant du commutateur étant réalisé dans l'état non déformé de la membrane.

Selon une caractéristique particulière de l'invention pour la configuration série ou pour la seconde configuration parallèle correspondant au troisième mode de réalisation, la masse RF de membrane peut être constituée de deux pistes de masse RF situées de part et d'autre de la piste de membrane.

Selon une autre caractéristique particulière de l'invention pour la première configuration parallèle, la masse RF de membrane peut être constituée de deux pistes de masse RF situées de part et d'autre de la piste de substrat. Pour la piste de substrat, la masse RF de membrane est configurée de telle sorte que sa projection dans le plan de la piste de substrat est située de part et d'autre de la piste de substrat.

Selon une autre caractéristique particulière de l'invention, la piste de membrane et les deux pistes de masse RF peuvent être dans un même plan parallèle au substrat.

Selon une autre caractéristique particulière de l'invention, la masse RF de membrane peut comprendre en outre au moins l'une parmi une piste de masse RF située au-dessus de la piste de membrane et d'une piste de masse RF située au-dessous de la piste de membrane, la piste de masse RF de la masse RF de membrane située au-dessus de la piste de membrane s'étendant sur au moins une partie de la largeur de la membrane entre les ancrages et l'extrémité de la piste de membrane reliée à la zone de contact, et la piste de masse RF de la masse RF de membrane située au-dessous de la piste de membrane s'étendant sur au moins une partie de la largeur de la membrane entre les ancrages et l'extrémité de la piste de membrane reliée à la zone de contact, laissant libre la zone de contact.

On assure ainsi un guidage optimal du signal RF dans la membrane pour la configuration série.

Les pistes de masse RF de la masse RF de membrane peuvent être connectées par des vias dans la membrane pratiqués de part et d'autre de la piste conductrice.

Selon une autre caractéristique particulière de l'invention, la zone de contact de la membrane est un plot de contact en saillie de la face inférieure de la membrane pour réaliser un contact physique conducteur du plot de contact avec la piste de substrat dans l'état déformé de la membrane.

Le plot de contact peut avantageusement être constitué de l'un parmi un métal du groupe du platine, les oxydes d'un métal du groupe du platine ou leurs combinaisons.

Selon une autre caractéristique particulière de l'invention, la masse RF de membrane est sur la face inférieure de la membrane, en regard du substrat.

Le commutateur microélectromécanique peut comprendre en outre au moins l'une parmi une seconde piste de membrane et une seconde masse RF de membrane formées symétriquement à la piste de membrane par rapport à un plan parallèle au substrat et médian suivant l'épaisseur de la membrane, et la seconde masse RF étant symétrique de la masse RF de membrane par rapport à un plan parallèle au substrat et médian suivant l'épaisseur de la membrane.

Cette configuration permet ainsi de limiter les déflexions de la membrane en température causées par les différences d'expansion thermique des matériaux constituant la membrane.

Selon une configuration particulière de l'invention, la première ligne de signal RF et la deuxième ligne de signal RF sont coplanaires, la membrane est arrondie, maintenue espacée du substrat par cinq ancrages formés sur le substrat, le moyen d'activation électrostatique étant constitué par une électrode d'activation électrostatique formée sur le substrat en regard de la membrane et alimentée par une ligne d'activation, l'électrode d'activation étant configurée, lorsqu'elle est activée par la ligne d'activation, pour amener la membrane à son état déformé.

Le commutateur microélectromécanique selon l'invention peut notamment être réalisé par une succession de dépôts et de gravures de couches minces de matériaux. Les dépôts sont réalisés par des appareils de dépôt connus dans le domaine de la microélectronique (évaporateurs thermiques, canons à électrons, pulvérisateurs cathodiques DC et RF, ablation laser... etc). La gravure des matériaux peut être assistée par des procédés de photolithographie permettant de définir des motifs. La gravure peut être réalisée à l'aide de solutions chimiques (par exemple acide fluorhydrique, acide chlorhydrique, hydroxyde de tétraméthylammonium (TMAH)...) ou à l'aide de plasmas d'O₂, de CF₄ ou de SF₆...

Pour mieux illustrer l'objet de la présente invention, nous allons en décrire ci-après, à titre illustratif et non limitatif, un mode de réalisation particulier, avec référence aux dessins annexés.

Sur ces dessins :
- les Figures 1, 1a, 1b et 1c sont respectivement des vues schématiques de dessus, en coupe longitudinale selon la ligne AA', en coupe longitudinale selon la ligne BB' et en coupe transversale selon la ligne CC' de la Figure 1 d'un commutateur microélectromécanique (MEMS) selon une première variante d'un premier mode de réalisation de l'invention ;
- les Figures 2a, 2b et 2c sont respectivement des vues schématiques en coupe longitudinale selon une ligne AA', en coupe longitudinale selon une ligne BB' et en coupe transversale selon une ligne CC' analogues à celle de la Figure 1 d'un commutateur microélectromécanique (MEMS) selon une seconde variante du premier mode de réalisation de l'invention ;
- les Figure 3a et 3b sont des vues schématiques analogues aux Figures 2b et 2c d'un commutateur microélectromécanique (MEMS) selon une troisième variante du premier mode de réalisation de l'invention ;
- les Figures 4, 4a, 4b, 4c et 4d sont respectivement des vues schématiques de dessus, en coupe longitudinale selon la ligne AA', en coupe longitudinale selon la ligne BB', en coupe transversale selon la ligne CC' et en coupe transversale selon la ligne DD' de la Figure 4 d'un commutateur microélectromécanique (MEMS) selon un deuxième mode de réalisation de l'invention ;
- les Figures 5, 5a, 5b, 5c et 5d sont respectivement des vues schématiques de dessus, en coupe longitudinale selon la ligne AA', en coupe longitudinale selon la ligne BB', en coupe transversale selon la ligne CC' et en coupe transversale selon la ligne DD' de la Figure 5 d'un commutateur microélectromécanique (MEMS) selon un troisième mode de réalisation de l'invention ;
- les Figures 6a et 6b sont respectivement une vue de dessus et une vue en perspective éclatée d'une mise en œuvre du commutateur microélectromécanique (MEMS) selon le premier mode de réalisation de l'invention ;
- les Figures 7a et 7b sont respectivement une vue de dessus et une vue en perspective éclatée d'une mise en œuvre du commutateur microélectromécanique (MEMS) selon le deuxième mode de réalisation de l'invention ; et
- les Figures 8a et 8b sont des courbes de performance d'un commutateur série selon la présente invention, respectivement dans l'état non activé et activé.

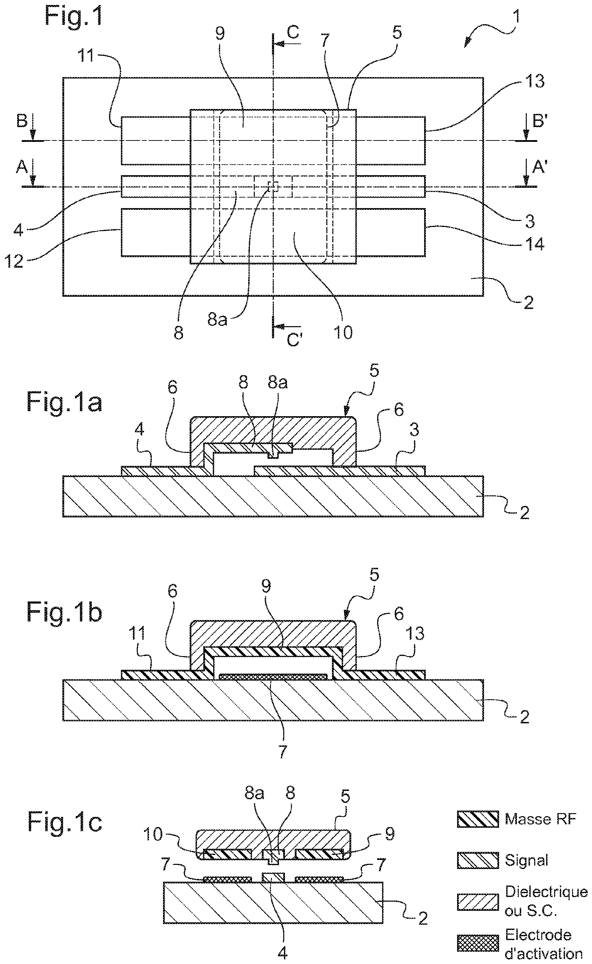

Si l'on se réfère aux Figures 1, 1a, 1b et 1c, on peut voir que l'on y a représenté une première variante d'un commutateur microélectromécanique 1 selon un premier mode de réalisation de l'invention, ce premier mode de réalisation correspondant à une configuration dite série.

Le commutateur microélectromécanique 1 comprend un substrat 2, sur la surface supérieure duquel sont formées une première ligne de signal RF 3 et une deuxième ligne de signal RF 4 dans l'alignement de la première ligne de signal RF 4, la première ligne de signal RF 3 et la deuxième ligne de signal RF 4 ayant la même direction. L'une de la première ligne de signal RF 3 et de la deuxième ligne de signal RF 4 constitue la ligne d'entrée de signal RF du commutateur microélectromécanique 1, l'autre de la première ligne de signal RF 3 et de la deuxième ligne de signal RF 4 constituant sa ligne de sortie de signal RF.

Une membrane, qui peut être diélectrique ou semiconductrice, déformable 5 est maintenue espacée du substrat 2 par deux ancrages 6. La membrane 5 sera supposée diélectrique dans les modes de réalisation ci-dessous, sans que cela soit limitatif.

La membrane diélectrique déformable 5 est déformable entre une première position, dite non déformée, dans laquelle la membrane diélectrique 5 est telle que représentée sur la Figure 1a, maintenue parallèle ou sensiblement parallèle au substrat 2 par les ancrages 6 au-dessus du substrat 2, et une position dite déformée décrite plus en détail ci-après.

Une électrode d'activation 7, constituée deux parties, est disposée sous la membrane diélectrique 5, et lorsque l'électrode d'activation 7 est alimentée (alimentation non représentée sur la représentation schématique des Figures), elle attire la membrane diélectrique 5 pour l'amener à adopter son état déformé. Bien que l'activation représentée sur les figures soit une activation de type électrostatique, l'activation peut être une activation électrostatique, une activation piézoélectrique, une activation thermique ou une activation par induction, l'invention n'étant pas limitée à cet égard.

Une piste de membrane 8 est formée dans la membrane diélectrique 5, ladite piste de membrane 8 étant dans ce premier mode de réalisation reliée par l'intermédiaire de l'ancrage 6 à la deuxième ligne de signal RF 4 et présentant une saillie 8a sous la forme d'un plot sous la membrane diélectrique 5, ladite saillie 8a étant destinée à entrer en contact avec la première ligne de signal RF 3 dans l'état déformé de la membrane diélectrique 5, afin qu'un signal RF puisse passer de la première ligne de signal RF 3 à la deuxième ligne de signal RF 4 par l'intermédiaire de la piste de membrane 8 dans l'état déformé de la membrane diélectrique 5, et ne pas passer de la première ligne de signal RF 3 à la deuxième ligne de signal RF 4 dans l'état non déformé de la membrane diélectrique 5, afin de constituer un commutateur électrostatique 1 commandé par activation de l'électrode d'activation 7.

Des masses RF de membrane 9 et 10 sont également formées dans la membrane diélectrique 5, parallèlement à la piste de membrane 8 et dans le même plan que celle-ci, et sont reliées par l'intermédiaire des ancrages 6 à des masses RF 11, 12, 13 et 14 formées sur le substrat 2, parallèlement aux première et deuxième lignes de signal RF 3 et 4 et dans le même plan que celles-ci.

L'ensemble des masses RF 9, 10, 11, 12, 13, 14 et les lignes de signal 3 et 4 forment ainsi un guide d'ondes pour un signal RF se déplaçant, dans l'état déformé de la membrane diélectrique 5, entre la première ligne de signal RF 3 et la deuxième ligne de signal RF 4, les masses RF 13 et 14 réalisant un guide d'ondes pour le signal RF sur la première ligne de signal RF 3, les masses RF 9 et 10 réalisant un guide d'ondes pour un signal RF se déplaçant sur la piste de membrane 8, et les masses RF 11 et 12 réalisant un guide d'ondes pour un signal RF se déplaçant sur la deuxième ligne de signal RF 4, le signal RF étant ainsi guidé tout au long de son passage à travers le commutateur microélectromécanique 1.

Il est à noter que, sans s'écarter du cadre de la présente invention, le signal RF pourrait symétriquement se déplacer dans la direction de la deuxième ligne de signal RF 4 à la première ligne de signal RF 3, le sens de déplacement indiqué en liaison avec la description des Figures 1, 1a, 1b et 1c ci-dessus étant uniquement destiné à illustrer le fonctionnement du commutateur microélectromécanique 1 et n'étant pas entendu limiter l'invention à cet égard.

Les masses RF 11, 12, 13 et 14 constituent également des masses DC permettant d'établir une différence de potentiel avec l'électrode qui, une fois polarisée, activera le commutateur microélectromécanique 1.

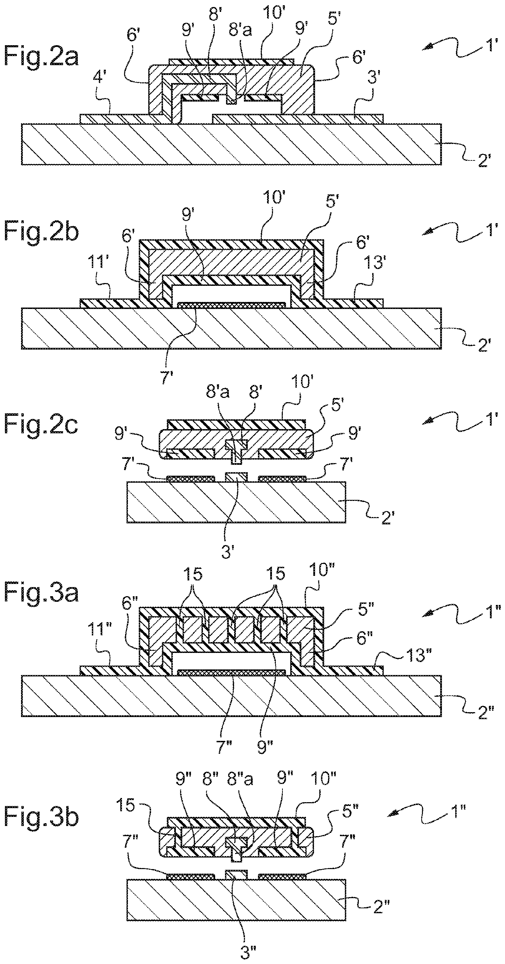

Si l'on se réfère maintenant aux Figures 2a, 2b et 2c, on peut voir qu'il y est représenté un commutateur microélectromécanique 1' selon une seconde variante du premier mode de réalisation.

La vue de dessus de cette seconde variante du premier mode de réalisation n'est pas représentée en raison du nombre de couches qui rendraient la figure difficilement lisible. Les lignes de coupe AA', BB' et CC' sont cependant analogues à celles de la Figure 1 et correspondent donc respectivement à une coupe longitudinale médiane, une coupe longitudinale latérale et une coupe transversale médiane du commutateur microélectromécanique 1' selon la seconde variante du premier mode de réalisation.

Les éléments identiques aux éléments de la première variante du premier mode de réalisation décrits en référence aux Figures 1, 1a-1c porteront le même chiffre de référence suivi du symbole « ' », et ne seront pas décrits en détail lorsqu'ils ont la même structure que dans la première variante du premier mode de réalisation.

Dans cette seconde variante du premier mode de réalisation, le substrat 2' porte, comme dans la première variante du premier mode de réalisation, les masses RF 11' et 13', ainsi que l'électrode d'activation 7' (les autres masses RF correspondant aux masses RF 12 et 14 de la Figure 1 ne sont pas représentées pour ne pas multiplier le nombre de Figures, mais sont également bien entendu présentes dans cette seconde variante du premier mode de réalisation).

La différence avec la première variante réside dans la position des masses RF de membrane 9' et 10'. Ainsi, dans la seconde variante, une première masse RF de membrane 9' est formée sur la face inférieure de la membrane diélectrique 5', en regard de la surface du substrat 2' portant l'électrode d'activation 7', et une seconde masse RF de membrane 10' est formée sur la face supérieure de la membrane diélectrique 5', la piste de membrane 8' s'étendant entre les deux masses RF de membrane 9' et 10', entre l'un des ancrages 6' et sensiblement le centre de la membrane diélectrique 5', la saillie 8a', reliée à la piste de membrane 8', faisant comme dans la première variante du premier mode de réalisation saillie sous la membrane diélectrique 5', en regard de la première ligne de signal RF 3', dans une ouverture formée dans la masse RF de membrane 9'.

La masse RF de membrane 10' s'étend sur toute la surface supérieure de la membrane diélectrique 5', la masse RF de membrane 9' s'étendant uniquement sur une partie de la surface inférieure de la membrane diélectrique 5', afin de permettre à la saillie 8a' de déboucher sur la surface inférieure de la membrane diélectrique 5' à l'extrémité de celle-ci pour effectuer un contact électrique avec la première ligne de signal RF 3' dans l'état déformé de la membrane diélectrique 5'.

La troisième variante du premier mode de réalisation représentée sur les Figures 3a et 3b est identique à la deuxième variante, et les éléments identiques portent les mêmes chiffres de référence qu'aux Figures 2a, 2b et 2c, suivi d'un nouveau symbole « ' ».

La structure et le positionnement des éléments étant le même que dans les Figures 2a, 2b et 2c, ceux-ci ne seront pas décrits en détail lorsque leur structure ne change pas. La différence entre les deuxième et troisième variantes du premier mode de réalisation réside dans la présence de vias 15 entre les première et seconde masse RF de membrane 9" et 10", permettant un guidage d'ondes amélioré pour le signal RF circulant dans la membrane 5" sur la piste de membrane 8", par rapport à la première variante.

D'autres variantes non décrites afin de ne pas multiplier le nombre de figures entrent dans le cadre de la présente invention. Il pourrait ainsi être envisagé d'avoir comme masse RF de membrane uniquement une masse RF similaire à la deuxième masse RF 10' de la seconde variante du premier mode de réalisation, ou encore uniquement une masse RF similaire à la première masse RF 9' de la seconde variante du premier mode de réalisation, ou encore une combinaison de masses RF des première et deuxième variantes, à savoir deux masses RF encadrant la piste de membrane comme les masses RF 9 et 10 des Figures 1a-1c, et deux masses RF au-dessous et au-dessus de la piste de membrane comme dans les Figures 2a-2b-2c, avec ou sans vias comme dans les Figures 3a et 3b. Toutes ces variantes entrent dans le cadre de la présente invention, sans que l'invention soit pour autant limitée à celles-ci.

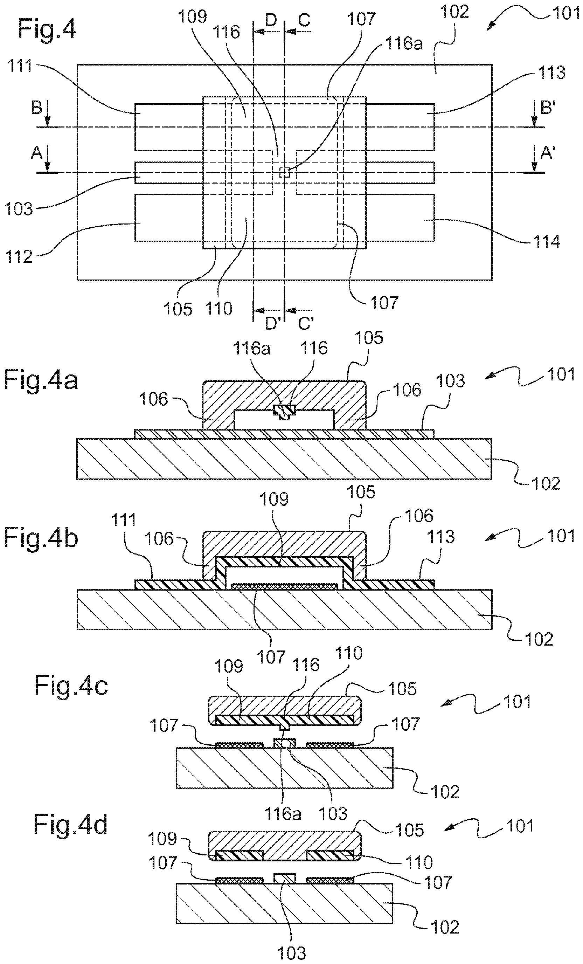

Si l'on se réfère aux Figures 4, 4a-4c, on peut voir qu'il y est représenté un commutateur microélectromécanique 101 selon un deuxième mode de réalisation de l'invention, appelé première configuration parallèle. Les éléments identiques ou analogues aux éléments de la première variante du premier mode de réalisation porteront le même chiffre de référence augmenté de 100, et ne seront pas décrits plus en détail ici.

Dans ce deuxième mode de réalisation, le commutateur microélectromécanique 101 comprend, disposés sur le substrat 102, une piste de substrat 103, s'étendant transversalement sous la membrane diélectrique 105, sensiblement selon la médiane de la membrane diélectrique 105, la piste de substrat 103 transportant dans ce deuxième mode de réalisation le signal RF à travers le commutateur microélectromécanique 101.

En amont et en aval de la membrane diélectrique 105 sont formés sur le substrat 102 quatre masses RF 111, 112, 113 et 114, les masses RF en amont 113 et 114 s'arrêtant au niveau de l'ancrage 106 de la membrane, les masses RF en aval 111 et 112 débutant à partir de l'extrémité de la membrane diélectrique 105, le rôle de ces masses RF 111, 112, 113 et 114 étant de constituer un guide d'ondes pour le signal RF sur la piste de substrat 103, en amont et en aval de la membrane diélectrique 105, les masses 113 et 114 constituant à elles seules la masse DC nécessaire à l'activation.

Entre les masses RF 111, 112, 113 et 114, toujours sur le substrat 102 et sous la membrane diélectrique 105, une électrode d'activation 107 (en deux parties comme dans le premier mode de réalisation) est formée de part et d'autre de la piste de substrat 103, afin de déformer la membrane diélectrique 105. L'électrode d'activation 107 peut être constituée de deux éléments alimentés séparément ou d'un seul élément, la connexion entre les deux éléments de part de d'autre de la piste de substrat 103 étant alors réalisée dans le substrat 102.

Dans la membrane 105 sont formées deux masses RF de membrane 109 et 110, s'étendant dans la membrane 105 parallèlement à la piste de substrat 103, de part et d'autre de celle-ci de telle sorte que les projections des masses RF de membrane 109 et 110 dans le plan de la piste de substrat 103 sont de part et d'autre de la piste de substrat 103 et parallèles à celle-ci.

Les masses RF de membrane 109 et 110 sont reliées aux masses RF 111 et 112 par l'intermédiaire des ancrages 106 et sont reliées sensiblement en leur milieu par un pont 116.

Dans le mode de réalisation représenté sur les Figures 4, 4a-4c, les masses RF de membrane 109 et 110 sont formées sur la surface inférieure de la membrane diélectrique 105, de telle sorte que leur surface inférieure s'ouvre sous la membrane diélectrique 105. Ainsi, dans ce mode de réalisation, le pont 116 débouche lui aussi sous la membrane diélectrique 105 et permet, lors d'une déformation de la membrane diélectrique 105 par l'électrode d'activation 107, de court-circuiter le signal RF qui circule sur la piste de substrat 103, par l'intermédiaire de la saillie 116a similaire à la saillie 8a de la Figure la.

Il est à noter qu'il pourrait également être envisagé que les masses RF de membrane 109 et 110 soient entièrement noyées dans la membrane diélectrique 105, auquel cas il serait nécessaire que la saillie 116a, reliée au pont 116, fasse saillie sur la surface inférieure de la membrane diélectrique 105 afin de permettre un contact électrique avec la piste de substrat 103.

Dans ce mode de réalisation comme dans tous les autres modes de réalisation, le contact de la membrane diélectrique dans son état déformé avec un élément sur le substrat peut être soit par contact direct de la surface inférieure de la membrane diélectrique avec l'élément sur le substrat, soit par l'intermédiaire d'une saillie ou d'un plot formé sur la surface inférieure de la membrane diélectrique et en saillie de celle-ci, le plot étant connecté dans la membrane diélectrique avec l'élément qui doit être mis en contact avec l'élément sur le substrat.

Ainsi, contrairement au premier mode de réalisation dans lequel le signal RF traverse le commutateur microélectromécanique en passant par la membrane diélectrique lorsque celle-ci est déformée, le signal RF traverse dans le deuxième mode de réalisation le commutateur microélectromécanique lorsque la membrane diélectrique n'est pas déformée, et est court-circuité lorsque la membrane diélectrique est déformée.

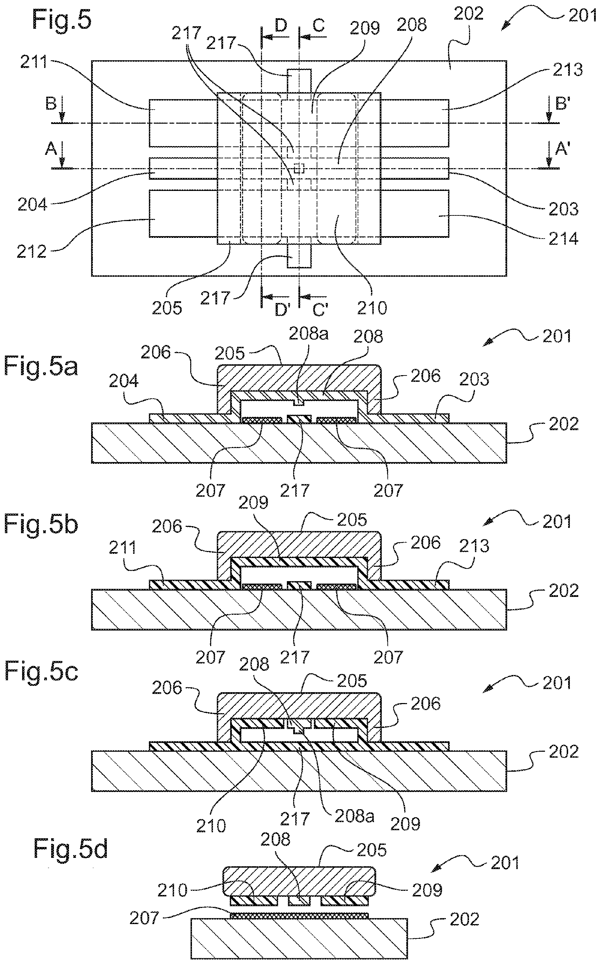

Si l'on se réfère maintenant aux Figures 5, 5a-5c, on peut voir qu'il y est représenté un commutateur microélectromécanique 201 selon un troisième mode de réalisation de l'invention, appelé deuxième configuration parallèle. Les éléments identiques ou analogues aux éléments de la première variante du premier mode de réalisation porteront le même chiffre de référence augmenté de 200, et ne seront pas décrits plus en détail ici.

Dans ce troisième mode de réalisation, le commutateur microélectromécanique 201 comprend, disposés sur le substrat 202, une première ligne de signal RF 203, une deuxième ligne de signal RF 204 parallèle à la première ligne de signal RF 203 et dans le prolongement de celle-ci.

Des masses RF de substrat 213 et 214 formées sur le substrat 202 sont formées parallèlement à la première ligne de signal 203 et parallèlement à celle-ci, tandis que les masses RF de substrat 211 et 212 sont formées parallèlement à la deuxième ligne de signal 204 et parallèlement à celle-ci.

La membrane diélectrique 205 est maintenue espacée du substrat 202 par deux ancrages 206 situés à deux côtés opposés de la membrane diélectrique 205, la membrane diélectrique 205 portant une piste de membrane 208 et deux masses RF 209 et 210, situées de part et d'autre de la piste de membrane 208 et dans le même plan que celle-ci. La piste de membrane porte une saillie 208a orientée vers le substrat 202, pour faire un contact électrique dans l'état déformé de la membrane diélectrique 205, à la manière de la saillie 8a du premier mode de réalisation (première variante).

La piste de membrane 208 est reliée respectivement aux première et deuxième lignes de signal RF 203 et 204 par l'intermédiaire des ancrages 206, de telle sorte que dans la configuration non déformée de la membrane diélectrique 205, le signal RF traverse le commutateur microélectromécanique 201 de la première ligne de signal RF 203 à la deuxième ligne de signal RF 204 (ou dans l'autre sens) par l'intermédiaire de la piste de membrane 208. Les deux masses RF de membrane 209 et 210 sont quant à elles connectées par l'intermédiaire des ancrages 206 aux masses RF de substrat 211, 212, 213 et 214.

Deux électrodes d'activation 207 sont formées parallèles sous la membrane diélectrique 205, transversalement à la direction de la piste de membrane 208, et servent comme dans les autres modes de réalisation à déformer la membrane diélectrique 205. Comme pour les autres modes de réalisation, l'alimentation des électrodes d'activation 207 est omise pour ne pas surcharger la figure.

Entre les deux électrodes d'activation 207, sur le substrat 202, est formée une piste de masse 217, parallèle aux deux électrodes d'activation 207 et donc orthogonale à la direction de la piste de membrane 208, de telle sorte que la projection du centre de la piste de membrane 208 dans le plan de la piste de masse 217 correspond sensiblement au centre de la piste de masse 217. La piste de masse 217 est reliée par l'intermédiaire des ancrages 206 aux masses RF de membrane 209 et 210.

Comme pour les autres modes de réalisation, bien que la piste de membrane 208 soit représentée schématiquement comme ayant une surface (surface inférieure) débouchant directement sous la surface de la membrane diélectrique 205, il peut être envisagé, sans s'écarter du cadre de la présente invention, que la piste de membrane 208 soit noyée dans la membrane diélectrique 205, reliée par un via à la surface inférieure de la membrane diélectrique 205 et à la saillie 208a, afin de réaliser un contact avec un élément sur le substrat.

Les deux électrodes d'activation 207, conjuguées à la symétrie des ancrages 206 de part et d'autre de la membrane diélectrique 205 induisent une déformation de la membrane diélectrique 205 en son centre, de telle sorte que la saillie 208a dans ce mode de réalisation est située sous la membrane diélectrique 205, au droit du centre de la piste de masse RF 217.

Comme dans le deuxième mode de réalisation, l'état déformé de la membrane diélectrique 205 correspond à un court-circuit et donc à un arrêt de passage de signal RF à travers le commutateur microélectromécanique 201, et l'état non déformé de la membrane diélectrique 205 correspond au passage du signal RF à travers le commutateur 201, à la différence, par rapport au deuxième mode de réalisation, qu'au lieu de passer sur une piste située sur le substrat, le signal RF dans ce troisième mode de réalisation passe par la membrane diélectrique 205.

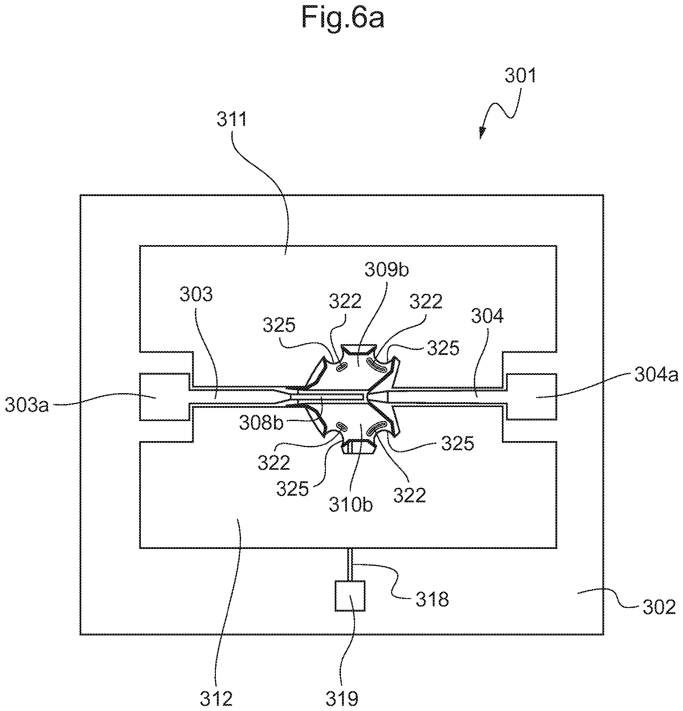

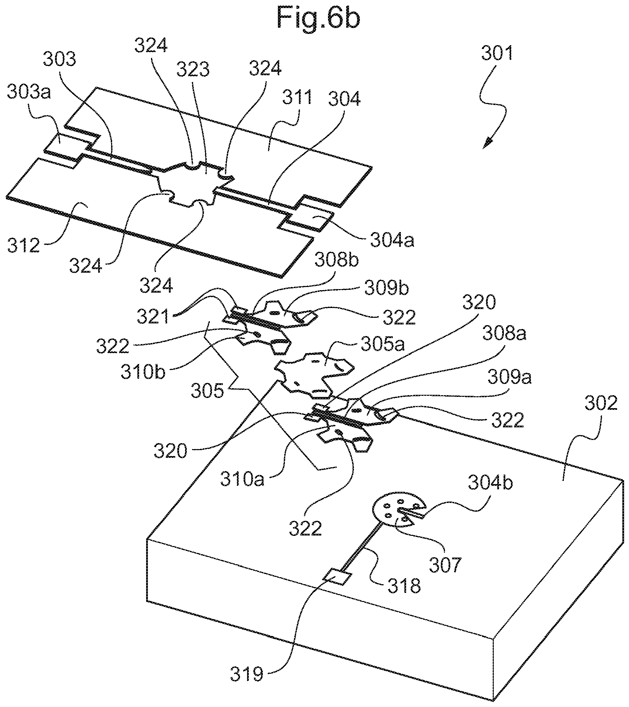

Si l'on se réfère maintenant aux Figures 6a et 6b, on peut voir que l'on y a représenté une mise en œuvre d'un commutateur microélectromécanique 301 selon le premier mode de réalisation.

Les éléments communs aux éléments de la première variante du premier mode de réalisation sont désignés par le même chiffre de référence, augmenté de 300.

Sur un substrat 302 sont ainsi formées une première ligne de signal RF 303 et une deuxième ligne de signal RF 304, accessibles respectivement par l'intermédiaire des plages 303a et 304a.

Une électrode d'activation 307 est également formée sur le substrat 302, reliée par l'intermédiaire d'une piste d'alimentation 318 à une plage 319 permettant de brancher une alimentation électrique (non représentée) pour activer l'électrode d'activation 307.

Dans cette mise en œuvre particulière et non limitative de l'invention, l'électrode d'activation 307 est en forme de disque dont aurait été supprimé un quartier, une piste de substrat 304b s'étendant suivant la bissectrice du quartier manquant, ladite piste de substrat 304b n'étant pas en contact avec l'électrode d'activation 307, mais étant en contact avec la deuxième piste de signal RF 304 lorsque le commutateur microélectromécanique 301 n'est pas activé.

La membrane diélectrique 305 est constituée de trois couches empilées : une première couche (couche inférieure) comprenant deux pistes de masse RF 309a et 310a encadrant la piste de membrane 308a, une couche diélectrique 305a, une seconde couche symétrique de la première couche, et comprenant deux pistes de masse RF 309b et 310b encadrant une piste de membrane 308b. Des plages 320 permettent d'alimenter les masses RF 309a, 310a, 309b et 310b.

Comme on peut le voir sur la Figure 6a, la membrane diélectrique 305 complète présente une forme correspondant sensiblement à la forme de l'électrode d'activation 307, si ce n'est que des creux 325 sont formés symétriquement de part et d'autre d'une direction correspondant à la direction de la piste de membrane 308b, lesdits creux 325 correspondant à des avancées arrondies des pistes de masse 311 et 312, afin de permettre une déformation optimale de la membrane diélectrique 305 lors d'une activation par l'électrode d'activation 307.

La membrane diélectrique 305 se loge dans un espace 323 formé entre les pistes de masse RF 311 et 312.

Les parties de la membrane diélectrique 305 entre les creux 325 constituent les ancrages permettant de relier les pistes de masse RF 309a, 309b, 310a et 310b aux masses RF 311 et 312, l'ancrage de la membrane diélectrique 305 dans l'axe de la piste de membrane 308a, 308b permettant de relier la piste de membrane 308a, 308b à la première ligne de signal RF 303. Des saillies arrondies 324 correspondantes sont formées sur les pistes de masse Rf 311 et 312.

Les trous 322 formés sur la membrane diélectrique 305 permettent d'optimiser la déformation de la membrane diélectrique 305.

Bien que cela ne soit pas représenté sur les Figures 6a, 6b, un plot est de préférence en saillie sous la piste de membrane 308a, afin de garantir un contact avec la piste de substrat 304b dans l'état déformé de la membrane diélectrique 305, afin de faire passer un signal RF provenant de la première ligne de signal RF 303 sur la piste de membrane 308a, 308b puis sur la deuxième ligne de signal RF 304.

La symétrie des couches 309a, 310a, 308a et 309b, 310b, 308b permet de limiter les déflexions de la membrane en température causées par les différences d'expansion thermique des matériaux constituant la membrane.

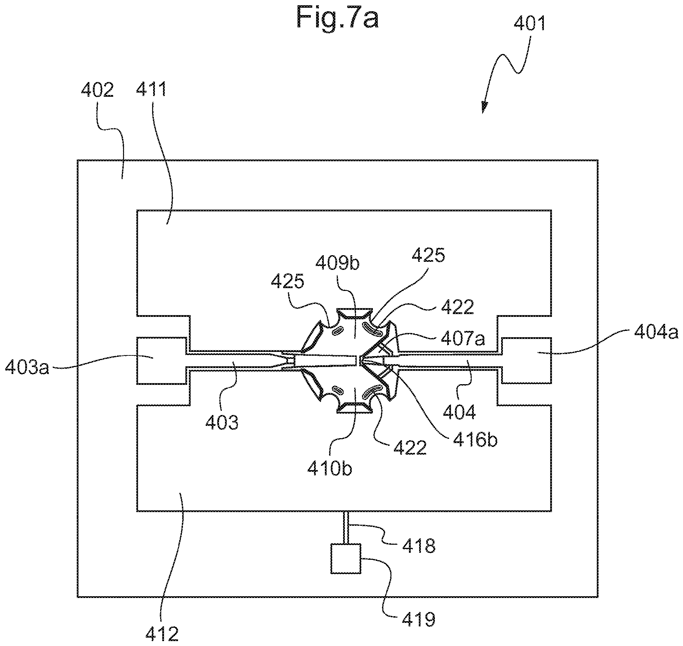

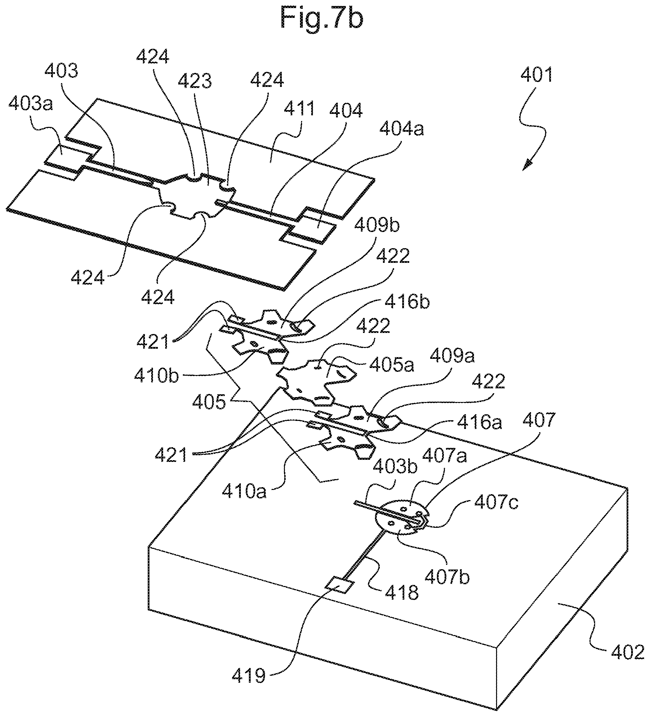

Si l'on se réfère maintenant aux Figures 7a et 7b, on peut voir que l'on y a représenté une mise en œuvre d'un commutateur microélectromécanique 401 selon le deuxième mode de réalisation.

Les éléments communs aux éléments du deuxième mode de réalisation sont désignés par le même chiffre de référence, augmenté de 400.

Sur un substrat 402 sont ainsi formées une première ligne de signal RF 403 et une deuxième ligne de signal RF 404, accessibles respectivement par l'intermédiaire des plages 403a et 404a.

Une électrode d'activation 407 est également formée sur le substrat 402, reliée par l'intermédiaire d'une piste d'alimentation 418 à une plage 419 permettant de brancher une alimentation électrique (non représentée) pour polariser le composant et l'activer.

Dans cette mise en œuvre particulière et non limitative de l'invention, l'électrode d'activation 307 est constituée de deux demi-disques 407a et 407b, séparés par une piste de substrat 403b formée sur le substrat 402 et symétriques par rapport à celle-ci, et dont il manque un quartier sur le côté de l'électrode d'activation 407 dirigé vers la deuxième ligne de signal RF 404 lorsque le commutateur microélectromécanique 401 est assemblé.

Les deux demi-disques 407a et 407b sont reliés par une piste 407c formée dans l'espace libre formé par les quartiers manquants des demi-disques 407a et 407b, la piste 407a contournant la piste de substrat 403b.

La membrane diélectrique 405 est constituée de trois couches empilées : une première couche (couche inférieure) comprenant deux pistes de masse RF 409a et 410a reliées par un pont 416a, une couche diélectrique 405a, une seconde couche symétrique de la première couche, et comprenant deux pistes de masse RF 409b et 410b reliées par un pont 416b. Des plages 421 permettent d'alimenter les masses RF 409a, 410a, 409b et 410b.

Comme on peut le voir sur la Figure 7a, la membrane diélectrique 405 complète présente une forme correspondant sensiblement à la forme de l'électrode d'activation 407, si ce n'est que des creux 425 sont formés symétriquement de part et d'autre d'une direction correspondant à la direction de la piste de substrat 403a, lesdits creux 425 correspondant à des avancées arrondies des pistes de masse 411 et 412, afin de permettre une déformation optimale de la membrane diélectrique 405 lors d'une activation par l'électrode d'activation 407.

La membrane diélectrique 405 se loge dans un espace 423 formé entre les pistes de masse RF 411 et 412.

Les parties de la membrane diélectrique 405 entre les creux 425 constituent les ancrages permettant de relier les pistes de masse RF 409a, 409b, 410a et 410b aux masses RF 411 et 412. Dans l'état non déformé de la membrane diélectrique 405, la deuxième ligne de signal RF 404 est en contact avec la piste de substrat 403b. Des saillies arrondies 424 correspondantes sont formées sur les pistes de masse Rf 411 et 412.

Les trous 422 formés sur la membrane diélectrique 405 permettent d'optimiser la déformation de la membrane diélectrique 405.

Bien que cela ne soit pas représenté sur les Figures 7a, 7b, un plot est de préférence en saillie sous le pont 416a, afin de garantir un contact avec la piste de substrat 403b dans l'état déformé de la membrane diélectrique 405, afin de faire un court-circuit d'un signal RF circulant de la première ligne de signal RF 403 à la deuxième ligne de signal RF 404, le signal RF circulant sur la piste de substrat 403b étant envoyé directement à la masse dans l'état déformé de la membrane diélectrique 405.

La symétrie des couches 409a, 410a, 416a et 409b, 410b, 416b permet de limiter les déflexions de la membrane en température causées par les différences d'expansion thermique des matériaux constituant la membrane.

Pour une description plus détaillée des avantages de la forme d'un tel composant, on pourra se reporter à la demande de brevet français FR3027448 au nom de la Demanderesse.

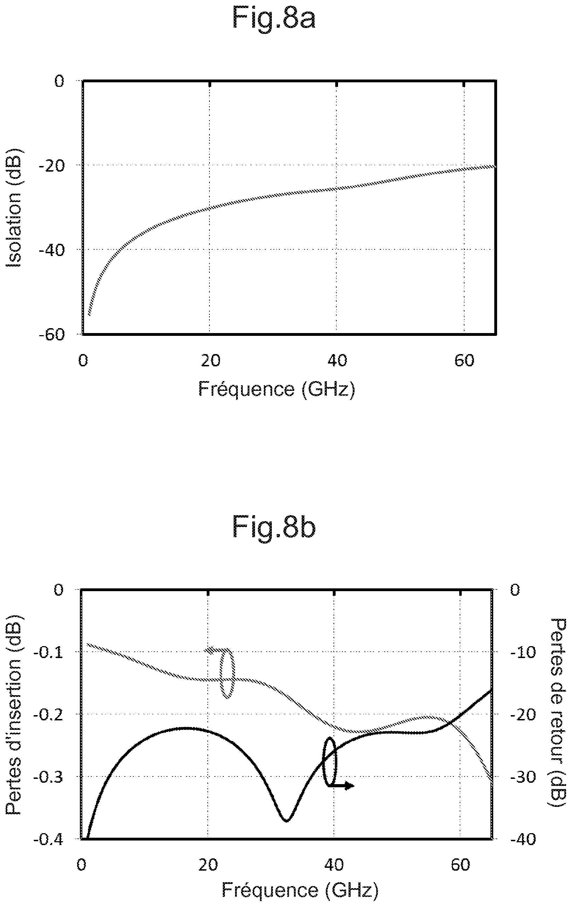

La Figure 8a représente l'isolation en fonction de la fréquence pour le commutateur en configuration série à l'état non activé.

La Figure 8b représente les pertes d'insertion et le niveau d'adaptation en fonction de la fréquence pour le commutateur en configuration série à l'état activé.

## Revendications

1. Commutateur microélectromécanique (MEMS) (1 ; 1' ; 1" ; 101 ; 201 ; 301 ; 401) formé sur un substrat (2 ; 2' ; 2" ; 202 ; 302 ; 402), le commutateur microélectromécanique (1 ; 1' ; 1" ; 101 ; 201 ; 301 ; 401) comprenant :
- une première ligne de signal RF (3 ; 3' ; 3" ; 103 ; 203 ; 303 ; 403) et une deuxième ligne de signal RF (4 ; 4' ; 4" ; 204 ; 304 ; 404) formées sur le substrat (2 ; 2' ; 2" ; 202 ; 302 ; 402) ;
- une membrane déformable en matériau hautement résistif, (5 ; 5' ; 5" ; 105 ; 205 ; 305 ; 405), la membrane (5 ; 5' ; 5" ; 105 ; 205 ; 305 ; 405) étant maintenue, dans un état non déformé, espacée du substrat (2 ; 2' ; 2" ; 202 ; 302 ; 402) par des moyens d'ancrage (6 ; 6' ; 6" ; 106 ; 206) solidaires du substrat (2 ; 2' ; 2" ; 202 ; 302 ; 402),
- un moyen d'activation (7 ; 7' ; 7" ; 107 ; 207 ; 307 ; 407) configuré pour déformer la membrane (5 ; 5' ; 5" ; 105 ; 205 ; 305 ; 405) à partir de son état non déformé,
- une piste de substrat (103) formée sur le substrat (2 ; 2' ; 2" ; 202; 302; 402), en regard de la membrane (5 ; 5' ; 5" ; 105 ; 205 ; 305 ; 405),
- une piste de membrane (8 ; 8' ; 8" ; 208 ; 308a, 308b) intégrée à la membrane (5 ; 5' ; 5" ; 105 ; 205 ; 305 ; 405) et portant une zone de contact conductrice (8a ; 8a' ; 8a" ; 208a) en regard de la piste de substrat (103) configurée pour réaliser un contact conducteur entre la piste de substrat (103) et la piste de membrane dans un état déformé de la membrane (8 ; 8' ; 8" ; 208 ; 308a, 308b), la première ligne de signal RF (3 ; 3' ; 3" ; 103 ; 203 ; 303 ; 403) et la deuxième ligne de signal RF (4 ; 4' ; 4" ; 204 ; 304 ; 404) étant reliées par l'intermédiaire d'au moins l'une parmi la piste de membrane (8 ; 8' ; 8" ; 208 ; 308a, 308b) et la piste de substrat (103), le commutateur (1 ; 1' ; 1" ; 101 ; 201 ; 301 ; 401) étant à l'état passant lorsqu'un signal est apte à circuler de la première ligne de signal RF (3 ; 3' ; 3" ; 103 ; 203 ; 303 ; 403) à la deuxième ligne de signal RF (4 ; 4' ; 4" ; 204 ; 304 ; 404), et à l'état bloqué lorsqu'un signal ne peut pas circuler de la première ligne de signal RF (3 ; 3' ; 3" ; 103 ; 203 ; 303 ; 403) à la deuxième ligne de signal RF (4 ; 4' ; 4" ; 204 ; 304 ; 404),
**caractérisé par le fait qu'**une masse RF de membrane (9, 10 ; 9', 10' ; 9", 10" ; 109, 110 ; 209, 210 ; 309a, 309b, 310a, 310b ; 409a, 409b, 410a, 410b) est intégrée à la membrane (5 ; 5' ; 5" ; 105 ; 205 ; 305 ; 405), la masse RF de membrane (9, 10 ; 9', 10' ; 9", 10" ; 109, 110 ; 209, 210 ; 309a, 309b, 310a, 310b ; 409a, 409b, 410a, 410b) étant reliée électriquement à une masse RF de substrat (11, 12, 13, 14 ; 11', 13' ; 11", 13" ; 111, 112, 113, 114 ; 211, 212, 213, 214 ; 311, 312 ; 411, 412) par l'intermédiaire des ancrages (6 ; 6' ; 6" ; 106 ; 206), la masse RF de membrane (9, 10 ; 9', 10' ; 9", 10" ; 109, 110 ; 209, 210 ; 309a, 309b, 310a, 310b ; 409a, 409b, 410a, 410b) encadrant et étant formée parallèlement à au moins l'une parmi la piste de membrane (8 ; 8' ; 8" ; 208 ; 308a, 308b) et la piste de substrat (103), de telle sorte que la masse RF (9, 10 ; 9', 10' ; 9", 10" ; 109, 110 ; 209, 210 ; 309a, 309b, 310a, 310b ; 409a, 409b, 410a, 410b) épouse le trajet de signal RF, pour guider la propagation du signal RF de la première ligne de signal RF (3 ; 3' ; 3" ; 103 ; 203 ; 303 ; 403) à la deuxième ligne de signal RF (4 ; 4' ; 4" ; 204 ; 304 ; 404) lorsque le commutateur est à l'état passant.

2. Commutateur microélectromécanique (MEMS) (1 ; 1' ; 1" ; 301) selon la revendication 1, **caractérisé par le fait que** la piste de membrane (8 ; 8' ; 8" ; 308a ; 308b) est reliée au niveau d'une extrémité à la première ligne de signal RF (3 ; 3' ; 3" ; 303) et la piste de substrat est reliée à la deuxième ligne de signal RF (4 ; 4' ; 4" ; 304), l'état passant du commutateur (1 ; 1' ; 1" ; 301) étant réalisé dans l'état déformé de la membrane (5 ; 5' ; 5" ; 305), et l'état bloqué du commutateur (1 ; 1' ; 1" ; 301) étant réalisé dans un état non déformé de la membrane (5 ; 5' ; 5" ; 305).

3. Commutateur microélectromécanique (MEMS) (201) selon la revendication 1, **caractérisé par le fait que** la première ligne de signal RF (203) et la deuxième ligne de signal RF (204) sont reliées par la piste de membrane (208), la piste de substrat étant reliée à la masse RF (209, 210), l'état bloqué du commutateur (201) étant réalisé dans l'état déformé de la membrane (205), et l'état passant du commutateur (201) étant réalisé dans l'état non déformé de la membrane (205).

4. Commutateur microélectromécanique (MEMS) (101 ; 401) selon la revendication 1, **caractérisé par le fait que** la première ligne de signal RF (103 ; 403) et la deuxième ligne de signal RF (404) sont reliées par la piste de substrat (103), la piste de membrane étant reliée à la masse RF (109 ; 409a, 409b ; 410a, 410b), l'état bloqué du commutateur (101 ; 401) étant réalisé dans l'état déformé de la membrane (105 ; 405), et l'état passant du commutateur (101 ; 401) étant réalisé dans l'état non déformé de la membrane (105 ; 405).

5. Commutateur microélectromécanique (1 ; 1' ; 1" ; 201 ; 301) selon la revendication 2 ou la revendication 3, **caractérisé par le fait que** la masse RF de membrane (9, 10 ; 9', 10' ; 9", 10" ; 209, 210 ; 309a, 309b, 310a, 310b) est constituée de deux pistes de masse RF (9, 10 ; 9', 10' ; 9", 10" ; 209, 210 ; 309a, 309b, 310a, 310b) situées de part et d'autre de la piste de membrane (8 ; 8' ; 8" ; 208 ; 308a, 308b).

6. Commutateur microélectromécanique (101 ; 401) selon la revendication 4, **caractérisé par le fait que** la masse RF de membrane (109 ; 409a, 409b ; 410a,410b) est constituée de deux pistes de masse RF (109 ; 409a, 409b ; 410a,410b) situées de part et d'autre de la piste de substrat (103).

7. Commutateur microélectromécanique (1 ; 1' ; 1" ; 101 ; 201 ; 301 ; 401) selon la revendication 5 ou la revendication 6, **caractérisé par le fait que** la piste de membrane (8 ; 8' ; 8" ; 208 ; 308a, 308b) et les deux pistes de masse RF (9, 10 ; 9', 10' ; 9", 10" ; 109, 110 ; 209, 210 ; 309a, 309b, 310a, 310b ; 409a, 409b, 410a, 410b) sont dans un même plan parallèle au substrat (2 ; 2' ; 2" ; 202; 302; 402).

8. Commutateur microélectromécanique (1 ; 1' ; 1" ; 101 ; 201 ; 301 ; 401) selon l'une des revendications 2, 3, 5 et 6, **caractérisé par le fait que** la masse RF de membrane (9, 10 ; 9', 10' ; 9", 10" ; 109, 110 ; 209, 210 ; 309a, 309b, 310a, 310b ; 409a, 409b, 410a, 410b) comprend en outre au moins l'une parmi une piste de masse RF (10' ; 10") située au-dessus de la piste de membrane (8 ; 8' ; 8" ; 208 ; 308a ; 308b) et d'une piste de masse RF (9' ; 9") située au-dessous de la piste de membrane (8 ; 8' ; 8" ; 208 ; 308a ; 308b), la piste de masse RF (10' ; 10") de la masse RF de membrane (9, 10 ; 9', 10' ; 9", 10" ; 109, 110 ; 209, 210 ; 309a, 309b, 310a, 310b ; 409a, 409b, 410a, 410b) située au-dessus de la piste de membrane (8 ; 8' ; 8" ; 208 ; 308a ; 308b) s'étendant sur au moins une partie de la largeur de la membrane (5 ; 5' ; 5" ; 105 ; 205 ; 305 ; 405) entre les ancrages (6 ; 6' ; 6" ; 106 ; 206) et l'extrémité de la piste de membrane (8 ; 8' ; 8" ; 208 ; 308a ; 308b) reliée à la zone de contact (8a ; 8a' ; 8a" ; 208a), et la piste de masse RF (9' ; 9") de la masse RF de membrane (9, 10 ; 9', 10' ; 9", 10" ; 109, 110 ; 209, 210 ; 309a, 309b, 310a, 310b ; 409a, 409b, 410a, 410b) située au-dessous de la piste de membrane (8 ; 8' ; 8" ; 208 ; 308a ; 308b) s'étendant sur au moins une partie de la largeur de la membrane (5 ; 5' ; 5" ; 105 ; 205 ; 305 ; 405) entre les ancrages (6 ; 6' ; 6" ; 106 ; 206) et l'extrémité de la piste de membrane (8 ; 8' ; 8" ; 208 ; 308a ; 308b) reliée à la zone de contact (8a ; 8a' ; 8a" ; 208a), laissant libre la zone de contact (8a ; 8a' ; 8a" ; 208a).

9. Commutateur microélectromécanique (1") selon la revendication 8, **caractérisé par le fait que** les pistes de masse RF (9", 10") de la masse RF de membrane (9", 10") sont connectées par des vias (15) pratiqués de part et d'autre de la piste conductrice (8").

10. Commutateur microélectromécanique (1 ; 1' ; 1" ; 101 ; 201 ; 301 ; 401) selon l'une des revendications 1 à 9, **caractérisé par le fait que** la zone de contact (8a ; 8a' ; 8a" ; 208a) de la membrane (5 ; 5' ; 5" ; 105 ; 205 ; 305 ; 405) est un plot de contact (8a ; 8a' ; 8a" ; 208a) en saillie de la face inférieure de la membrane (5 ; 5' ; 5" ; 105 ; 205 ; 305 ; 405) pour réaliser un contact physique conducteur du plot de contact (8a ; 8a' ; 8a" ; 208a) avec la piste de substrat (103) dans l'état déformé de la membrane (5 ; 5' ; 5" ; 105 ; 205 ; 305 ; 405).

11. Commutateur microélectromécanique (1 ; 1' ; 1" ; 101 ; 201 ; 301 ; 401) selon l'une des revendications 1 à 10, **caractérisé par le fait que** la membrane (5 ; 5' ; 5" ; 105 ; 205 ; 305 ; 405) est en matériau diélectrique, ayant une résistance électrique supérieure à 5x10⁴ Ohms.cm.

12. Commutateur microélectromécanique (1 ; 1' ; 1" ; 101 ; 201 ; 301 ; 401) selon l'une des revendications 1 à 11, **caractérisé par le fait que** la masse RF de membrane (9, 10 ; 9', 10' ; 9", 10" ; 109, 110 ; 209, 210 ; 309a, 309b, 310a, 310b ; 409a, 409b, 410a, 410b) est sur la face inférieure de la membrane (5 ; 5' ; 5" ; 105 ; 205 ; 305 ; 405), en regard du substrat (2 ; 2' ; 2" ; 202 ; 302 ; 402) .

13. Commutateur microélectromécanique (301) selon l'une des revendications 2, 3 et 5, **caractérisé par le fait qu'**il comprend en outre au moins l'une parmi une seconde piste de membrane (308a, 308b) et une seconde masse RF de membrane (309a, 309b, 310a, 310b) formées symétriquement à la piste de membrane (308a, 308b) par rapport à un plan parallèle au substrat (302) et médian suivant l'épaisseur de la membrane (305), et la seconde masse RF (309a, 309b, 310a, 310b) étant symétrique de la masse RF de membrane (309a, 309b, 310a, 310b) par rapport à un plan parallèle au substrat (302) et médian suivant l'épaisseur de la membrane (305).

14. Commutateur microélectromécanique (MEMS) (301 ; 401) selon l'une des revendications 2, 4 à 7 et 9 à 13, **caractérisé par le fait que** la première ligne de signal RF (303 ; 403) et la deuxième ligne de signal RF (304 ; 404) sont coplanaires, la membrane (305 ; 405) est arrondie, maintenue espacée du substrat (302 ; 402) par cinq ancrages formés sur le substrat (302 ; 402), le moyen d'activation électrostatique (307 ; 407) étant constitué par une électrode d'activation électrostatique (307 ; 407) formée sur le substrat (302 ; 402) en regard de la membrane (305 ; 405) et alimentée par une ligne d'activation (318, 418), l'électrode d'activation (307 ; 407) étant configurée, lorsqu'elle est activée par la ligne d'activation (318 ; 418), pour amener la membrane (305 ; 405) à son état déformé.

## Patentansprüche

1. Mikroelektromechanischer Umschalter (MEMS) (1; 1'; 1"; 101; 201; 301; 401), der auf einem Substrat (2; 2'; 2"; 202; 302; 402) gebildet ist, wobei der mikroelektromechanische Umschalter (1; 1'; 1"; 101; 201; 301; 401) umfasst:
- eine erste RF-Signalleitung (3; 3'; 3"; 103; 203; 303; 403) und eine zweite RF-Signalleitung (4; 4'; 4"; 204; 304; 404), die auf dem Substrat (2; 2'; 2"; 202; 302; 402) gebildet sind;
- eine verformbare Membran aus hochresistivem Material (5; 5'; 5"; 105; 205; 305; 405), wobei die Membran (5; 5'; 5"; 105; 205; 305; 405) in einem nicht verformten Zustand, beabstandet vom Substrat (2; 2'; 2"; 202; 302; 402) von Verankerungsmitteln (6; 6'; 6"; 106; 206) gehalten wird, die mit dem Substrat (2; 2'; 2"; 202; 302; 402) fest verbunden sind,
- ein Aktivierungsmittel (7; 7'; 7"; 107; 207; 307; 407), das konfiguriert ist, um die Membran (5; 5'; 5"; 105; 205; 305; 405) aus ihrem nicht verformten Zustand zu verformen,
- eine Substratbahn (103), die auf dem Substrat (2; 2'; 2"; 202; 302; 402) gegenüber der Membran (5; 5'; 5"; 105; 205; 305; 405) gebildet ist,
- eine Membranbahn (8; 8'; 8"; 208; 308a, 308b), die in die Membran (5; 5'; 5"; 105; 205; 305; 405) integriert ist und eine leitende Kontaktzone (8a; 8a'; 8a"; 208a) gegenüber der Substratbahn (103) trägt, die konfiguriert ist, um einen leitenden Kontakt zwischen der Substratbahn (103) und der Membranbahn in einem verformten Zustand der Membran (8; 8'; 8"; 208; 308a, 308b) herzustellen, wobei die erste RF-Signalleitung (3; 3'; 3"; 103; 203; 303; 403) und die zweite RF-Signalleitung (4; 4'; 4"; 204; 304; 404) über mindestens eine von der Membranbahn (8; 8'; 8"; 208; 308a, 308b) und der Substratbahn (103) verbunden sind, wobei der Umschalter (1; 1'; 1"; 101; 201; 301; 401) im Ein-Zustand ist, wenn ein Signal imstande ist, von der ersten RF-Signalleitung (3; 3'; 3"; 103; 203; 303; 403) zur zweiten RF-Signalleitung (4; 4'; 4"; 204; 304; 404) zu zirkulieren, und im Aus-Zustand, wenn ein Signal nicht von der ersten RF-Signalleitung (3; 3'; 3"; 103; 203; 303; 403) zur zweiten RF-Signalleitung (4; 4'; 4"; 204; 304; 404) zirkulieren kann,
**dadurch gekennzeichnet, dass** eine RF-Membranmasse (9, 10; 9', 10'; 9", 10"; 109, 110; 209, 210; 309a, 309b, 310a, 310b; 409a, 409b, 410a, 410b) in die Membran (5; 5'; 5"; 105; 205; 305; 405) integriert ist, wobei die RF-Membranmasse (9, 10; 9', 10'; 9", 10"; 109, 110; 209, 210; 309a, 309b, 310a, 310b; 409a, 409b, 410a, 410b) mit einer RF-Substratmasse (11, 12, 13, 14; 11', 13'; 11", 13"; 111, 112, 113, 114; 211, 212, 213, 214; 311, 312; 411, 412) über Verankerungen (6; 6'; 6"; 106; 206) elektrisch verbunden ist, wobei die RF-Membranmasse (9, 10; 9', 10'; 9", 10"; 109, 110; 209, 210; 309a, 309b, 310a, 310b; 409a, 409b, 410a, 410b) einrahmt und parallel zu mindestens einer von der Membranbahn (8; 8'; 8"; 208; 308a, 308b) und der Substratbahn (103) derart gebildet ist, dass die RF-Masse (9, 10; 9', 10'; 9", 10"; 109, 110; 209, 210; 309a, 309b, 310a, 310b; 409a, 409b, 410a, 410b) dem RF-Signalweg folgt, um die Ausbreitung des RF-Signals von der ersten RF-Signalleitung (3; 3'; 3"; 103; 203; 303; 403) zur zweiten RF-Signalleitung (4; 4'; 4"; 204; 304; 404) zu steuern, wenn der Umschalter im Ein-Zustand ist.

2. Mikroelektromechanischer Umschalter (MEMS) (1; 1'; 11"; 301) nach Anspruch 1, **dadurch gekennzeichnet, dass** die Membranbahn (8; 8'; 8"; 308a; 308b) im Bereich eines Endes mit der ersten RF-Signalleitung (3; 3'; 3"; 303) verbunden ist und die Substratbahn mit der zweiten RF-Signalleitung (4; 4'; 4"; 304) verbunden ist, wobei der Ein-Zustand des Umschalters (1; 1'; 1"; 301) im verformten Zustand der Membran (5; 5'; 5"; 305) hergestellt ist und der Aus-Zustand des Umschalters (1; 1'; 1"; 301) in einem nicht verformten Zustand der Membran (5; 5'; 5"; 305) hergestellt ist.

3. Mikroelektromechanischer Umschalter (MEMS) (201) nach Anspruch 1, **dadurch gekennzeichnet, dass** die erste RF-Signalleitung (203) und die zweite RF-Signalleitung (204) durch die Membranbahn (208) verbunden sind, wobei die Substratbahn mit der RF-Masse (209, 210) verbunden ist, wobei der Aus-Zustand des Umschalters (201) im verformten Zustand der Membran (205) hergestellt ist und der Ein-Zustand des Umschalters (201) im nicht verformten Zustand der Membran (205) hergestellt ist.

4. Mikroelektromechanischer Umschalter (MEMS) (101; 401) nach Anspruch 1, **dadurch gekennzeichnet, dass** die erste RF-Signalleitung (103; 403) und die zweite RF-Signalleitung (404) durch die Substratbahn (103) verbunden sind, wobei die Membranbahn mit der RF-Masse (109; 409a, 409b; 410a, 410b) verbunden ist, wobei der Aus-Zustand des Umschalters (101; 401) im verformten Zustand der Membran (105; 405) hergestellt ist und der Ein-Zustand des Umschalters (101; 401) im nicht verformten Zustand der Membran (105; 405) hergestellt ist.

5. Mikroelektromechanischer Umschalter (1; 1'; 1"; 201; 301) nach Anspruch 2 oder Anspruch 3, **dadurch gekennzeichnet, dass** die RF-Membranmasse (9, 10; 9', 10'; 9", 10"; 209, 210; 309a, 309b, 310a, 310b) aus zwei Bahnen von RF-Masse (9, 10; 9', 10'; 9", 10"; 209, 210; 309a, 309b, 310a, 310b) besteht, die sich beiderseits der Membranbahn (8; 8'; 8"; 208; 308a, 308b) befinden.

6. Mikroelektromechanischer Umschalter (101 401) nach Anspruch 4, **dadurch gekennzeichnet, dass** die RF-Membranmasse (109; 409a, 409b; 410a, 410b) aus zwei Bahnen von RF-Masse (109; 409a, 409b; 410a, 410b) besteht, die sich beiderseits der Substratbahn (103) befinden.

7. Mikroelektromechanischer Umschalter (1; 1'; 1"; 101; 201; 301; 401) nach Anspruch 5 oder Anspruch 6, **dadurch gekennzeichnet, dass** die Membranbahn (8; 8'; 8"; 208; 308a, 308b) und die zwei Bahnen von RF-Masse (9, 10; 9', 10'; 9", 10"; 109, 110; 209, 210; 309a, 309b, 310a, 310b; 409a, 409b, 410a, 410b) in derselben Ebene parallel zum Substrat (2; 2'; 2"; 202; 302; 402) sind.

8. Mikroelektromechanischer Umschalter (1'; 1"; 101; 201; 301; 401) nach einem der Ansprüche 2, 3, 5 und 6, **dadurch gekennzeichnet, dass** die RF-Membranmasse (9, 10; 9', 10'; 9", 10"; 109, 110; 209, 210; 309a, 309b, 310a, 310b; 409a, 409b, 410a, 410b) ferner mindestens eine von einer Bahn von RF-Masse (10'; 10"), die sich oberhalb der Membranbahn (8; 8'; 8"; 208; 308a; 308b) befindet, und einer Bahn von RF-Masse (9'; 9"), die sich unterhalb der Membranbahn (8; 8'; 8"; 208; 308a; 308b) befindet, umfasst, wobei sich die Bahn von RF-Masse (10'; 10") der RF-Membranmasse (9, 10; 9', 10'; 9", 10"; 109, 110; 209, 210; 309a, 309b, 310a, 310b; 409a, 409b, 410a, 410b), die sich oberhalb der Membranbahn (8; 8'; 8"; 208; 308a; 308b) befindet, über mindestens einen Teil der Breite der Membran (5; 5'; 5"; 105; 205; 305; 405) zwischen den Verankerungen (6; 6'; 6"; 106; 206) und dem Ende der Membranbahn (8; 8'; 8"; 208; 308a; 308b), das mit der Kontaktzone (8a; 8a'; 8a"; 208a) verbunden ist, erstreckt, und sich die Bahn von RF-Masse (9'; 9") der RF-Membranmasse (9, 10; 9', 10'; 9", 10"; 109, 110; 209, 210; 309a, 309b, 310a, 310b; 409a, 409b, 410a, 410b), die sich unterhalb der Membranbahn (8; 8'; 8"; 208; 308a; 308b) befindet, über mindestens einen Teil der Breite der Membran (5; 5'; 5"; 105; 205; 305; 405) zwischen den Verankerungen (6; 6'; 6"; 106; 206) und dem Ende der Membranbahn (8; 8'; 8"; 208; 308a; 308b), das mit der Kontaktzone (8a; 8a'; 8a"; 208a) verbunden ist, erstreckt, wobei die Kontaktzone (8a; 8a'; 8a"; 208a) frei bleibt.

9. Mikroelektromechanischer Umschalter (1") nach Anspruch 8, **dadurch gekennzeichnet, dass** die Bahnen von RF-Masse (9", 10") der RF-Membranmasse (9", 10") durch Kontaktlöcher (15) angeschlossen sind, die beiderseits der Leitungsbahn (8") eingearbeitet sind.

10. Mikroelektromechanischer Umschalter (1; 1'; 1"; 101; 201; 301; 401) nach einem der Ansprüche 1 bis 9, **dadurch gekennzeichnet, dass** die Kontaktzone (8a; 8a'; 8a"; 208a) der Membran (5; 5'; 5"; 105; 205; 305; 405) ein Kontaktstück (8a; 8a'; 8a"; 208a) ist, das aus der unteren Fläche der Membran (5; 5'; 5"; 105; 205; 305; 405) hervorragt, um einen physischen leitenden Kontakt des Kontaktstücks (8a; 8a'; 8a"; 208a) mit der Substratbahn (103) im verformten Zustand der Membran (5; 5'; 5"; 105; 205; 305; 405) herzustellen.

11. Mikroelektromechanischer Umschalter (1; 1'; 1"; 101; 201; 301; 401) nach einem der Ansprüche 1 bis 10, **dadurch gekennzeichnet, dass** die Membran (5; 5'; 5"; 105; 205; 305; 405) aus dielektrischem Material mit einem elektrischen Widerstand über 5x10⁴ Ohm.cm ist.

12. Mikroelektromechanischer Umschalter (1; 1'; 1"; 101; 201; 301; 401) nach einem der Ansprüche 1 bis 11, **dadurch gekennzeichnet, dass** die RF-Membranmasse (9, 10; 9', 10'; 9", 10"; 109, 110; 209, 210; 309a, 309b, 310a, 310b; 409a, 409b, 410a, 410b) auf die untere Fläche der Membran (5; 5'; 5"; 105; 205; 305; 405) gegenüber dem Substrat (2; 2'; 2"; 202; 302; 402) ist.

13. Mikroelektromechanischer Umschalter (301) nach einem der Ansprüche 2, 3 und 5, **dadurch gekennzeichnet, dass** er ferner mindestens eine von einer zweiten Membranbahn (308a, 308b) und einer zweiten RF-Membranmasse (309a, 309b, 310a, 310b) umfasst, die symmetrisch zu der Membranbahn (308a, 308b) in Bezug auf eine Ebene parallel zum Substrat (302) und in der Mitte gemäß der Stärke der Membran (305) gebildet sind, und die zweite RF-Masse (309a, 309b, 310a, 310b) symmetrisch zu der RF-Membranmasse (309a, 309b, 310a, 310b) in Bezug auf eine Ebene parallel zum Substrat (302) und in der Mittel gemäß der Stärke der Membran (305) ist.

14. Mikroelektromechanischer Umschalter (MEMS) (301; 401) nach einem der Ansprüche 2, 4 bis 7 und 9 bis 13, **dadurch gekennzeichnet, dass** die erste RF-Signalleitung (303; 403) und die zweite RF-Signalleitung (304; 404) koplanar sind, die Membran (305; 405) abgerundet ist, beabstandet gehalten vom Substrat (302; 402) durch fünf Verankerungen, die auf dem Substrat (302; 402) gebildet sind, wobei das elektrostatische Aktivierungsmittel (307; 407) aus einer elektrostatischen Aktivierungselektrode (307; 407) besteht, die auf dem Substrat (302; 402) gegenüber der Membran (305; 405) gebildet ist und von einer Aktivierungsleitung (318, 418) versorgt wird, wobei die Aktivierungselektrode (307; 407) konfiguriert ist, wenn sie durch die Aktivierungsleitung (318; 418) aktiviert ist, um die Membran (305; 405) in ihren verformten Zustand zu führen.

## Claims

1. A micro-electromechanical switch (MEMS) (1; 1'; 1"; 101; 201; 301; 401) formed on a substrate (2; 2'; 2"; 202; 302; 402), the micro-electromechanical switch (1; 1'; 1"; 101; 201; 301; 401) comprising:
- a first RF signal line (3; 3'; 3"; 103; 203; 303; 403) and a second RF signal line (4; 4'; 4"; 204; 304; 404) formed on the substrate (2; 2'; 2"; 202; 302; 402);
- a deformable membrane made from a highly resistive material (5; 5'; 5"; 105; 205; 305; 405), the membrane (5; 5'; 5"; 105; 205; 305; 405) being kept, in a nondeformed state, spaced away from the substrate (2; 2'; 2"; 202; 302; 402) by anchoring means (6; 6'; 6"; 106; 206) secured to the substrate (2; 2'; 2"; 202; 302; 402),
- an activation means (7; 7'; 7"; 107; 207; 307; 407) configured to deform the membrane (5; 5'; 5"; 105; 205; 305; 405) from its nondeformed state,
- a substrate track (103) formed on the substrate (2; 2'; 2"; 202; 302; 402), opposite the membrane (5; 5'; 5"; 105; 205; 305; 405),
- a membrane track (8; 8'; 8"; 208; 308a, 308b) integrated into the membrane (5; 5'; 5"; 105; 205; 305; 405) and bearing a conductive contact zone (8a; 8a'; 8a"; 208a) opposite the substrate track (103) configured to produce a conductive contact between the substrate track (103) and the membrane track in a deformed state of the membrane (8; 8'; 8"; 208' 308a, 308b), the first RF signal line (3; 3'; 3"; 103; 203; 303; 403) and the second RF signal line (4; 4'; 4"; 204; 304; 404) being connected by means of at least one from among the membrane track (8; 8'; 8"; 208; 308a, 308b) and the substrate track (103), the switch (1; 1'; 1"; 101; 201; 301; 401) being in the on state when a signal is capable of circulating from the first RF signal line (3; 3'; 3"; 103; 203; 303; 403) to the second RF signal line (4; 4'; 4"; 204; 304; 404), and in the off state when a signal cannot circulate from the first RF signal line (3; 3'; 3"; 103; 203; 303; 403) to the second RF signal line (4; 4'; 4"; 204; 304; 404),
**characterized in that** an membrane RF ground (9, 10; 9', 10'; 9", 10"; 109, 110; 209, 210; 309a, 309b, 310a, 310b; 409a, 409b, 410a, 410b) is integrated into the membrane (5; 5'; 5"; 105; 205; 305; 405), the membrane RF ground (9, 10; 9', 10'; 9", 10"; 109, 110;, 209, 210; 309a, 309b, 310a, 310b; 409a, 409b, 410a, 410b) being electrically connected to an RF substrate ground (11, 12, 13, 14; 11', 13'; 11", 13"; 111, 112, 113, 114; 211, 212, 213, 214; 311, 312; 411, 412) by means of anchors (6; 6', 6"; 106; 206), the membrane RF ground (9, 10; 9', 10'; 9", 10"; 109, 110; 209, 210; 309a, 309b, 310a, 310b; 409a, 409b, 410a, 410b) framing and being formed parallel to at least one from among the membrane track (8; 8'; 8"; 208; 308a, 308b) and the substrate track (103), such that the RF ground (9, 10; 9', 10'; 9", 10"; 109, 110; 209, 210; 309a, 309b, 310a, 310b; 409a, 409b, 410a, 410b) closely follows the RF signal path, to guide the propagation of the RF signal from the first RF signal line (3; 3'; 3"; 103; 203; 303; 403) to the second RF signal line (4; 4'; 4"; 204; 304; 404) when the switch is in the on state.

2. The micro-electromechanical switch (MEMS) (1; 1'; 1"; 301) according to claim 1, **characterized in that** the membrane track (8; 8'; 8"; 308a, 308b) is connected at one end to the first RF signal line (3; 3'; 3"; 303) and the substrate track is connected to the second RF signal line (4; 4'; 4"; 304), the on state of the switch (1; 1'; 1"; 301) being made in the deformed state of the membrane (5; 5'; 5"; 305), and the off state of the switch (1; 1'; 1"; 301) being made in a nondeformed state of the membrane (5; 5'; 5"; 305).

3. The micro-electromechanical switch (MEMS) (201) according to claim 1, **characterized in that** the first RF signal line (203) and the second RF signal line (204) are connected by the membrane track (208), the substrate track being connected to the RF ground (209, 210), the off state of the switch (201) being made in the deformed state of the membrane (205), and the on state of the switch (201) being made in the nondeformed state of the membrane (205).

4. The micro-electromechanical switch (MEMS) (101; 401) according to claim 1, **characterized in that** the first RF signal line (103; 403) and the second RF signal line (404) are connected by the substrate track (103), the membrane track being connected to the RF ground (109; 409a, 409b; 410a, 410b), the off state of the switch (101; 401) being made in the deformed state of the membrane (105; 405), and the on state of the switch (101; 401) being made in the nondeformed state of the membrane (105; 405).

5. The micro-electromechanical switch (1; 1'; 1"; 201; 301) according to claim 2 or claim 3, **characterized in that** the membrane RF ground (9, 10; 9', 10'; 9", 10"; 209, 210; 309a, 309b, 310a, 310b) is made up of two RF ground tracks (9, 10; 9', 10'; 9", 10"; 209, 210; 309a, 309b, 310a, 310b) located on either side of the membrane track (8; 8', 8"; 208; 308a, 308b).

6. The micro-electromechanical switch (101; 401) according to claim 4, **characterized in that** the membrane RF ground (109; 409a, 409b; 410a, 410b) is made up of two RF ground tracks (109; 409a, 409b; 410a, 410b) located on either side of the substrate track (103).

7. The micro-electromechanical switch (1; 1'; 1"; 101; 201; 301; 401) according to claim 5 or claim 6, **characterized in that** the membrane track (8; 8'; 8"; 208; 308a, 308b) and the two RF ground tracks (9, 10; 9'; 10'; 9", 10"; 109, 110; 209, 210; 309a, 309b, 310a, 310b; 409a, 409b, 410a, 410b) are in a same plane parallel to the substrate (2; 2'; 2"; 202; 302; 402).

8. The micro-electromechanical switch (1; 1'; 1"; 101; 201; 301; 401) according to one of claims 2, 3, 5 and 6, **characterized in that** the membrane RF ground (9, 10; 9', 10'; 9", 10"; 109, 110; 209, 210; 309a, 309b, 310a, 310b; 409a, 409b, 410a, 410b) further comprises at least one from among an RF ground track (10'; 10") located above the membrane track (8; 8'; 8"; 208; 308a, 308b) and an RF ground track (9; 9") located below the membrane track (8; 8'; 8"; 208; 308a; 308b), the RF ground track (10'; 10") of the membrane RF ground (9, 10; 9', 10'; 9"; 10"; 109, 110; 209, 210; 309a, 309b, 310a, 310b; 409a, 409b, 410a, 410b) located above the membrane track (8; 8'; 8"; 208; 308a; 308b) extending over at least part of the width of the membrane (5; 5'; 5"; 105; 205; 305; 405) between the anchors (6; 6'; 6"; 106; 206) and the end of the membrane track (8; 8'; 8"; 208; 308a; 308b) connected to the contact zone (8a; 8a'; 8a"; 208a), and the RF ground track (9'; 9") of the membrane RF ground (9, 10; 9'; 10'; 9"; 10"; 109, 110; 209, 210; 309a, 309b, 310a, 310b; 409a, 409b, 410a, 410b) located below the membrane track (8; 8'; 8"; 208; 308a; 308b) extending over at least part of the width of the membrane (5; 5'; 5"; 105; 205; 305; 405) between the anchors (6; 6'; 6"; 106; 206) and the end of the membrane track (8; 8'; 8"; 208; 308a; 308b) connected to the contact zone (8a; 8a'; 8a"; 208a), leaving the contact zone (8a; 8a'; 8a"; 208a) free.

9. The micro-electromechanical switch (1") according to claim 8, **characterized in that** the RF ground tracks (9", 10") of the membrane RF ground (9", 10") are connected by vias in the membrane (15) formed on either side of the conductive track (8").

10. The micro-electromechanical switch (1; 1'; 1"; 101; 201; 301; 401) according to one of claims 1 to 9, **characterized in that** the contact zone (8a; 8a'; 8a"; 208a) of the membrane (5; 5'; 5"; 105; 205; 305; 405) is a contact pin (8a; 8a'; 8a"; 208a) protruding from the lower face of the membrane (5; 5'; 5"; 105; 205; 305; 405) to provide conductive physical contact of the contact pin (8a; 8a'; 8a"; 208a) with the substrate track (103) in the deformed state of the membrane (5; 5'; 5"; 105; 205; 305; 405).

11. The micro-electromechanical switch (1; 1'; 1"; 101; 201; 301; 401) according to one of claims 1 to 10, **characterized in that** the membrane (5; 5'; 5"; 105; 205; 305; 405) is made up of a dielectric material with an electric resistance greater than 5x10⁴ Ohms.cm.

12. The micro-electromechanical switch (1; 1'; 1"; 101; 201; 301; 401) according to one of claims 1 to 11, **characterized in that** the membrane RF ground (9, 10; 9', 10'; 9", 10"; 109, 110; 209, 210; 309a, 309b, 310a, 310b; 409a, 409b, 410a, 410b) is on the lower face of the membrane (5; 5'; 5"; 105; 205; 305; 405), opposite the substrate (2; 2'; 2"; 202; 302; 402).

13. The micro-electromechanical switch (301) according to one of claims 2, 3 and 5, **characterized in that** it further comprises at least one from among a second membrane track (308a, 308b) and a second membrane RF ground (309a, 309b, 310a, 310b) formed symmetrically to the membrane track (308a, 308b) relative to a plane parallel to the substrate (302) and median along the thickness of the membrane (305), and the second RF ground (309a, 309b, 310a, 310b) being symmetrical to the membrane RF ground (309a, 309b, 310a, 310b) relative to a plane parallel to the substrate (302) and median along the thickness of the membrane (305).

14. The micro-electromechanical switch (MEMS) (301; 401) according to one of claims 2, 4 to 7 and 9 to 13, **characterized in that** the first RF signal line (303; 403) and the second RF signal line (304; 404) are coplanar, the membrane (305; 405) is rounded, kept spaced away from the substrate (302; 402) by five anchors formed on the substrate (302; 402), the electrostatic actuation means (307; 407) being made up of an electrostatic activation electrode (307; 407) formed on the substrate (302; 402) opposite the membrane (305; 405) and power supplied by an activation line (318, 418), the activation electrode (307; 407) being configured, when it is activated by the activation line (318; 418), to bring the membrane (305; 405) to its deformed state.
